# EUROPEAN PATENT APPLICATION

(11) **EP 2 273 280 A1**
(43) Date of publication of application: **12.01.2011**
(21) Application number: 09165120.8
(22) Date of filing: 10.07.2009
(51) Int. Cl.: G01R 33/60, G01N 24/10, G01R 33/28

(54) **Pulsed EPR detection**

(71) Applicant: IMEC, 3001 Leuven (BE)
(72) Inventor: Vaes, Peter, 2820 Rijmenam (BE); Teugels, Stephanie, 3020 Herent (BE)
(74) Representative: Wauters, Davy Erik Angelo

(57) **Abstract**

A method and system for performing pulsed electron paramagnetic resonance is disclosed. The method comprises generating an excitation pulse train for applying to an object comprising probes and detecting from the probes an echo response induced by the excitation pulse train.

## Description

### Field of the invention

The invention relates to the field of electron paramagnetic resonance. More particularly, the present invention relates to methods and systems for applying pulsed electron paramagnetic resonance.

### Background of the invention

Magnetic resonance techniques are widely spread and find their application in amongst others detection and imaging. Whereas continuous working often may be inefficient as during a magnetic field scan most of the time baseline data is recorded between resonance responses, pulsed magnetic resonance typically uses the measurement time to a better effect. In pulsed magnetic resonance an impulse excitation is applied at the resonant frequency and the Fourier transform of the resulting free induction decay signal reveals the spectrum. The pulsed magnetic resonance technique may result in sensitivity advantages. In pulsed electro paramagnetic resonance (EPR) measurements, a short pulse is applied on a probe after which the magnetization of the probe is measured.

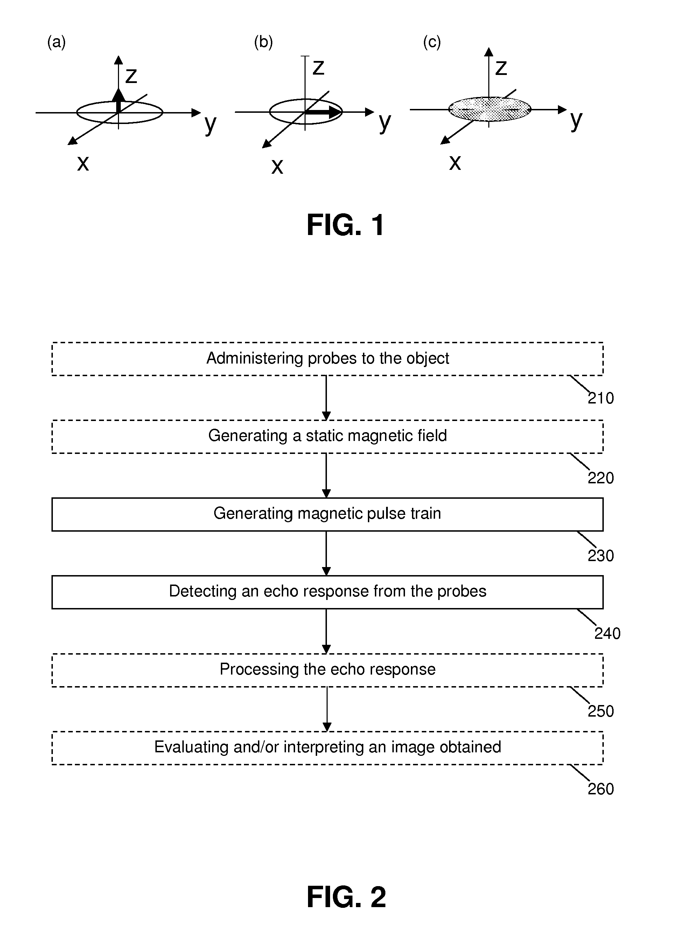

One problem with pulsed EPR is that the ring-down of the antenna caused by de-phasing of the spins, lasts longer than the free induction decay (FID), i.e. the signal to be detected, coming from the probe. This FID is longer when the line width of the probe is smaller. It consequently has been found previously that pulsed EPR should be limited to probes with a line width smaller than 3 MHz or that for pulsed EPR it is desirable to have spin probes, which have a very narrow single line spectrum because the transverse relaxation time is inversely proportional to line width. The problem of pulsed EPR for probes with a broad line width is shown in FIG. 1. FIG. 1 illustrates the initial alignment of spins with a static magnetic field along the Z-axis (part (a)), the subsequent alignment of the spins along the Y-axis after a Π/2 pulse, which would allow capturing of the probe signal by the antennas (part (b)), and the de-phasing of the spins resulting in the probe signal being not available (part (c)).

Some solutions have been provided to measure a short probe signal without being influenced by the ring-down time of the antennas. One known technique is the use of the Hahn echo. Using the Hahn echo, a first pulse will flip the spins 90 degrees with respect to the static magnetic field. During a period of time the tilted spins will de-phase (each with its own frequency), after which a second pulse will tilt the spins 180 degrees. Due to this pulse, the spins will re-phase. They will be re-phased exactly after a time equal to the time between the pulses. At this moment the echo can be measured.

It is also known to use pulse trains as a preparation technique for experiments. Some techniques are known for obtaining material characteristics wherein a set of three pulses is first used for creating a stimulated echo, and whereby a response of the material is induced by a re-phasing pulse. Other techniques use variations of applying pulses or pulse trains, but these all use a re-phasing pulse to induce a response of the material.

It is known to use shaped sinc pulses to achieve a more uniform power excitation over a relatively wide bandwidth region. For example, a truncated sinc pulse may be used to compensate for the Q-profile of the antenna.

It is also known, for techniques applying a pulse sequence, to correlate the input sequence with the measured result. One way to perform this is to change the phase between the pulses to eliminate the overlap of signals after multiple pulse sequences. Another example is correlating FIG with the input sequence, to decrease the total acquisition time and to improve the signal to noise ratio of the FID signal.

### Summary of the invention

It is an object of the present invention to provide good methods and system applying pulsed electron paramagnetic resonance (EPR). It is an advantage of embodiments according to the present invention that methods and systems are obtained allowing pulsed EPR detection on probes with broad line widths. It is an advantage of embodiments according to the present invention that methods and systems are provided that can be used with super-paramagnetic nano-particles and that allow full exploitation of the wide resonance of such super-paramagnetic nano-particles.

It is an advantage of embodiments according to the present invention that the power may be distributed over the sequence of pulses allowing tilting the spins gradually during each pulse and allowing a large overall power being applied for detection.

It is an advantage of embodiments according to the present invention that the power for individual frequencies can be adapted to the antenna system and/or to the resonance of the probes.

It is an advantage of embodiments of the present invention that a pulse sequence is used to selectively excite certain frequencies of the broadband probes, in order to create an echo sequence coming from the probes. The echo sequence coming from the probes thereby is based on positive interference.

It is an advantage of embodiments of the present invention that pulsed EPR methods and systems are provided allowing imaging of objects. It is an advantage of embodiments according to the present invention that a good imaging technique, e.g. in-vivo imaging technique, can be obtained. The latter can be obtained by generating an echo using a pulse train and using the echo for imaging.

It is an advantage of embodiments according to the present invention, over known systems using a sequence of pulses, that it exploits positive interference of the spins for detecting or imaging. The positive interference can be induced to occur on a periodic basis.

It is an advantage of embodiments according to the present invention that only a limited number of frequencies of the wideband resonance can be activated.

It is an advantage of embodiments according to the present invention that methods and systems are provided using pulse trains in order to generate an echo for imaging. The above objective is accomplished by a method and device according to the present invention.

The present invention relates to a method for performing pulsed electron paramagnetic resonance, the method comprising generating an excitation pulse train for applying to an object comprising probes, and detecting from the probes an echo response induced by the excitation pulse train. It is an advantage of embodiments according to the present invention that there is no need for a rephasing pulse, but that the response may be directly induced by the pulse train.

Generating an excitation pulse may comprise generating an excitation pulse inducing positive interference effects between responses of the probes for forming the echo response.

Detecting an echo response may comprise topologically imaging echo responses from probes distributed in the object.

Generating an excitation pulse may comprise selectively exciting predetermined frequencies of broadband probes of interest.

Detecting an echo response may comprise detecting an echo response from single domain particles.

Detecting an echo response may comprise detecting an echo response from wideband resonance super paramagnetic particles. The resonance response of the probe may occur in a wide band, e.g. between 3MHz and 400MHz. The wideband signal coming from the transmitter may be considered wideband if the frequency range in which the response occurs is larger than 20% of the central frequency, which may vary between 60MHz and 500MHz.

Generating an excitation pulse train may comprise generating a sequence of EPR pulses wherein the shape of the different EPR pulses is adapted for compensating at least partly for frequency dependency of the resonance of spin probes in the object.

It is an advantage of embodiments according to the present invention that compensation for frequency dependency of resonance of spin probes can be obtained as such frequency dependency becomes especially relevant for probes with large linewidths.

Generating an excitation pulse train may comprise generating a sequence of EPR pulses, whereby the intensity of the different EPR frequencies is adapted for compensating at least partly for power dependency of the resonance of spin probes in the object or of a detection system.

The method also may comprise generating a static magnetic field for applying to the object comprising spins for providing an initial alignment of the spins, wherein generating an excitation pulse train comprises generating pulses having a substantially different orientation than the static magnetic field.

The present invention also relates to a system for performing pulsed electron paramagnetic resonance, the system comprising an excitation pulse train generator for generating an excitation pulse train for applying to an object comprising probes, and a detection means for detecting from the probes an echo response induced by the excitation pulse train.

The excitation pulse train generator may comprise a controller for selectively exciting predetermined frequencies of broadband probes of interest and for generating an excitation pulse train positive interference effects between responses of probes for forming the echo response.

The detection means may be adapted for topologically imaging echo responses from probes distributed in the object.

The present invention furthermore relates to a method for preparing pulsed electron paramagnetic resonance measurements, wherein the method comprises designing an excitation pulse train adapted for inducing an echo response from probes, e.g. probes having a wide linewidth, based on positive interference between the individual responses of the probes to the individual frequencies of the excitation pulse train.

The present invention also relates to a computer program product for, when executed on a computing device, performing a method as described above. Furthermore, a data carrier comprising a computer program product as described above and/or transmission of such a computer program product over a network is also envisaged.

Particular and preferred aspects of the invention are set out in the accompanying independent and dependent claims. Features from the dependent claims may be combined with features of the independent claims and with features of other dependent claims as appropriate and not merely as explicitly set out in the claims. Embodiments of the invention will now further be discussed in the detailed description in conjunction with the drawings. The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Brief description of the drawings

FIG. 1 illustrates the problem of de-phasing of spins and its effect on the probe signals to be detected, as known from prior art.
FIG. 2 illustrates a flow chart of a method for performing pulsed electron paramagnetic resonance according to an embodiment of the present invention.
FIG. 3 illustrates an example of an excitation pulse train as can be used in a method for performing pulsed electron paramagnetic resonance according to an embodiment of the present invention.
FIG. 4 shows the Fourier Transform of the excitation pulse train shown in FIG. 3
FIG. 5 and FIG. 6 illustrate an excitation pulse and the corresponding probe echo response both in amplitude and in resulting orientation.
FIG. 7 illustrates an example of an excitation pulse train adapted to provide different power for different frequencies, as can be used in embodiments of the present invention.
FIG. 8 illustrates a Fourier Transform of the excitation pulse train shown in FIG. 7.
FIG. 9 illustrates a system for performing pulsed electron paramagnetic resonance according to an embodiment of the present invention.

### Detailed description of illustrative embodiments

In the following detailed description, numerous specific details are set forth in order to provide a thorough understanding of the invention and how it may be practiced in particular embodiments. However it will be understood that the present invention may be practiced without these specific details. In other instances, well-known methods, procedures and techniques have not been described in detail, so as not to obscure the present invention. While the present invention will be described with respect to particular embodiments and with reference to certain drawings, the reference is not limited hereto.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the steps or elements listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B. Where reference is made to the term consists of, the latter implies that no other elements are present.

Where in embodiments of the present application the term nano-particles is used, reference is made to particles having a critical dimension, e.g. diameter, in the range of 1 nm to 1000 nm. Certain embodiments make use of the magnetization of single domain particles. Single domain particles are defined as particles having a maximum coercivity for a given material occuring within its single domain range. Having larger grain sizes, coercivity decreases as the grain subdivides into domains. For smaller grain sizes, coercivity again decreases, but this time due to the randomizing effects of thermal energy. The critical size for single domain behavior depends on several factors including, the saturation magnetization and the shape of the grain. In single domain particles, the local magnetization is saturated but not necessarily parallel. Domains are larger than atomic distances and typically between 1 and 100 micrometer.

Super-paramagnetic particles are a specific class of single domain particles. As the particle size continues to decrease within the single domain range, the remanence and coercivity go to zero. When this happens, the grain becomes super-paramagnetic.

A single particle of volume v has a uniform magnetization directed along the easy axis of magnetization. If v is small enough, or the temperature is high enough, thermal energy (kT) will be sufficient to overcome the anisotropy energy separating the (+) and (-) magnetization states and cause a spontaneous reversal of magnetization

The measured signal of such single domain resonant particles is proportional to the magnetization. Therefore, it is beneficial to use particles made of a compound that show an electron paramagnetic resonance (EPR) with a magnetization being lower than the saturation magnetization.

Where in the present text reference is made to a broad line width, reference may be made to a line width of 3MHz or larger, e.g. in a range from 3MHz to 400MHz.

It is an advantage of embodiments according to the present invention that pulsed electron paramagnetic resonance methods and systems can be obtained providing good operation with probes having a broad line width, e.g. a line width of 3MHz or larger.

In a first aspect, the present invention relates to a method and system for performing pulsed electron paramagnetic resonance (EPR). Embodiments of the present invention may be especially suitable for imaging purposes, even when probes are used with broad line width. Embodiments of the present invention may be especially suitable for exploiting the wide resonances of single domain particles, e.g. of super-paramagnetic particles, e.g. super-paramagnetic nano-particles. The method for performing pulsed EPR comprises generating a train of pulses for applying to an object comprising probes and detecting an echo response induced by the train of pulses from the object comprising probes. The actual step of applying the train of pulses to the object, e.g. by directing the pulses, in that direction may or may not be part of the method. By way of illustration, the present invention not being limited thereto, the different standard and optional steps will be described in more detail, with reference to a flow chart of an exemplary method according to an embodiment of the present invention, as shown in FIG. 2.

In a first optional step 210, which may be an external step not part of the method for performing pulsed EPR on an object, administering of probes to the object may be performed. The latter may be performed using conventional techniques, such as for example, administering via a contrast liquid. The probes used for detecting and/or imaging may be single domain particles, such as for example super-paramagnetic particles as described above, although the invention is not limited thereto. In advantageous embodiments, the probes are administered intravenously. Such probes can be coated with different types of molecules depending on the target they should reach. One example thereof is coating with Dextran which will allow targeting the liver, but it is clear to the person skilled in the art that each suitable particle targeting the target of interest could be used. Selection may be based on the application envisaged. One example of a contrast agent that could be used is resovist. This contrast agent may for example comprise a concentration of 0.5 mmol Fe/ml.

For measurements, the method typically may comprise generating a static magnetic field, indicated as step 220. The generated static magnetic field may be generated by a static magnetic field generator or generating means for example using a permanent magnet, an electromagnet, etc. The generated static magnetic field may be for applying such a static magnetic field to an object, so that probes in an object can be oriented along the direction of the static magnetic field. By way of illustration, the present invention not being limited thereto, in the following description it is assumed that the static magnetic field results in an initial orientation of the probes along the Z-direction. A typical magnitude of the applied static magnetic field may for example be in the range having a lower limit of 1 Gauss and an upper limit of 300 Gauss. Moreover an additional field gradient can be applied. This means the static field will be different for different positions and this will allow obtaining a spatial resolution between the probes.

The method furthermore comprises generating 230 a train of excitation magnetic pulses for directing them towards the object comprising probes. The excitation magnetic pulses may be induced using a magnetic pulse generator or generating means, such as for example an electromagnet, a moving permanent magnet, etc. The pulses may, in some embodiments, be amplified and transmitted afterwards using an antenna, such as for example a coil antenna. The excitation pulse train thereby may comprise more than 2 pulses, advantageously more than 3 pulses. The total number of pulses advantageously depends on the power required for tilting the spins. As such it depends on the power available in one pulse, and on the probe itself. The pulses are oriented in the X-Y plane (original orientation of the spins is along the Z-axis). The important component of these pulses is rotating in the X-Y plane with a frequency corresponding with the Larmor frequency of the probe. It is this component that will tilt the electron-spin. The pulse height of the different excitation pulses may be in a range having a lower limit of 1mW and an upper limit of 10MW. The pulse shape used may be any suitable pulse shape, such as for example a sinc pulse or a modified sinc pulse. Other examples are block pulses or any other form created by summing the individual frequencies which are the most appropriate for generating the echo signal from the probe. Generating such a pulse train may be realized by summing a set of individual frequencies. The pulse train may be generated such that selectively certain frequencies of the probes, e.g. broadband probes are excited, so that an echo response is induced. The pulse train in the time domain may correspond with a frequency grating in the frequency domain. The distance between the pulses may be inversely proportional to the spacing between the frequencies. A typical length of the pulse train may be in a range having a lower limit of 10ns and an upper limit of 1ms.

The method also comprises the step of detecting 240 a response from the probes. Such a response may be detected using a detection means or detector, e.g. a receiving antenna. The probe spins in the object will transmit, as response to the pulse train generated, a pulse train having similar characteristics afterwards. More particularly, a pulse train with the same frequencies and with the same phase relations may be detected by a detection unit, e.g. a receiving antenna. The width in the frequency domain thereby will be inversely proportional to the pulse width of the pulses in the pulse train. As the response pulse train has the same frequencies and the same phase relations, it is referred to as an echo response. The response may be induced by positive interference between the individual exited frequencies. The response will be built up as from application of the exciting pulse train and will be continued after the exciting pulse train has finished.

The time between the last stimulus pulse and the echo signal (is inversely proportional to the frequency step. This time should be bigger than the dead-time of the receiving system to enable the detection of the echo signal. Since particles with broad line widths are used, this principle allows having an echo signal after the dead time of the receiver, and before the relaxation time of the particles.

Upon or after detection of the echo response, the method furthermore optionally may comprise processing 250 the echo response for deriving properties of the probes. Such properties may for example be presence of the probes, number of the probes present, etc. In an advantageous embodiment, detection of the echo response can be performed as function of the position of the probes, allowing generating an image of the probes. In other words the echo response may be recorded in a topologically consistent manner, allowing to make an image of the distribution of the probes in the object. Such detection may for example be performed by scanning the object with the receiving antenna. Alternatively or in addition thereto, a static magnetic field with a field gradient may be used. By applying a field gradient of the static magnetic field, and this in the different directions, the probes will have a different frequency response depending on their position. Moreover multiple antennas can be used, the position of the antennas can be changed and the orientation of the magnetic field gradient can be changed. These latter solutions provide the advantage of resulting in a fast imaging technique.

A further optional step, which may be part of the method or which may explicitly not be part of the method, may comprise evaluation and/or interpreting 260 an image obtained. The latter may for example be performed to derive a status of an object, monitor an evolution of an object, etc.

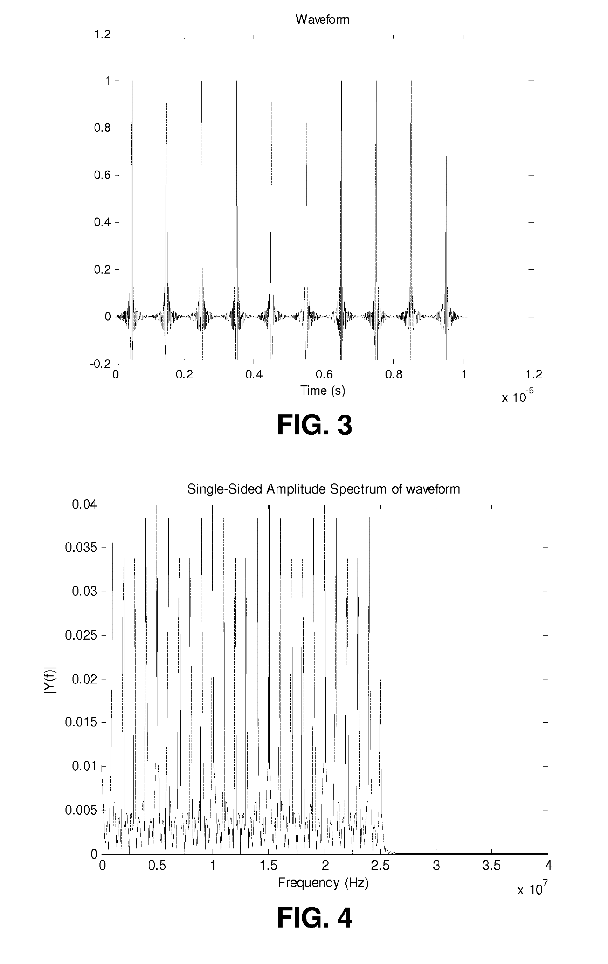

By way of illustration, the present invention not being limited thereto, an example of the pulse trains applied and obtained when performing an exemplary method according to an embodiment of the present invention are further discussed. By way of illustration, FIG. 3 shows a pulse train as can be generated and FIG. 4 illustrates a Fourier transform thereof. In the present example, the pulse train has a total bandwidth of 50 MHz and the spacing between the frequencies is 1 MHz. This results in spacing between the pulses of 1µs.

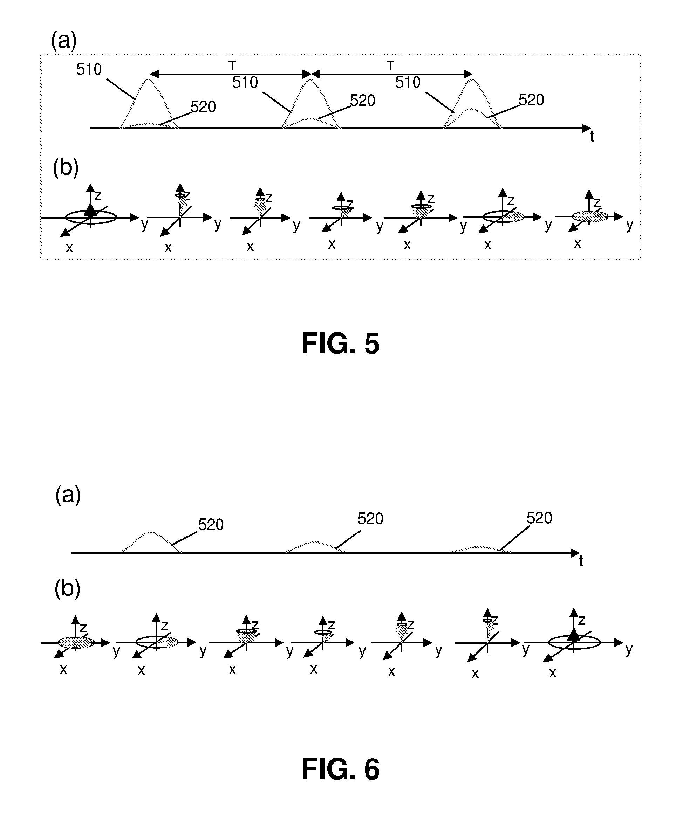

In FIG. 5, an example of an applied pulse train and the initial response of the probes is shown by way of illustration, the present invention not being limited thereto. In FIG. 5 part (a), pulses 510 are the pulses generated for applying to the object, whereas pulses 520 are the echo responses from the probes. It is to be noticed that the figure is illustrative and scales are not matching with reality. As indicated above, the distance between the pulses is the inverse of the frequency spacing. In FIG. 5 part (b), the initial response of the probes can be seen. The variation of the probe response in time is shown from left to right. In the drawing at the left, the initial orientation of the static magnetic field is shown, being the direction along which the probes will be oriented. It can be seen that initially in the present example, the probes are oriented along the Z-direction, i.e. the orientation provided by the static magnetic field. The next drawings each time illustrates the resulting magnetic moment of the electron spin. As reply to the pulses induced, the probes start to tilt towards the x-y plane. Between the pulses, the spins will de-phase since different frequencies are excited. After each pulse the spins will be tilted more towards the x-y plane and rephase. This means also that after each pulse the spins will generate a bigger signal. The pulse train is continued until the spins are tilted 90 degrees. Additionally the spins will try to align themselves with the static magnetic field along the Z-axis. When no further pulses are applied, the spins will align with the z-axis and upon alignment, the signal from the spins will be reduced to zero. After the initially applied pulse train has ended, the further resulting response signal coming from the probes is shown in FIG. 6. Again the overall reply is shown by pulses 520 in part (a), whereas the corresponding particular probe orientation is shown in part (b) indicating the spin magnetic moment and its de-phasing and re-phasing. As can be seen the reply of the probes is a pulse train having similar frequency and phase as the initially applied pulse train, and therefore can be referred to as an echo response.

In one embodiment, the characteristics of the excitation pulse train are selected so as to improve or optimize the signal to noise ratio. By increasing the step size between the frequencies the pulse repetition rate can be made faster. This allows putting more power during a shorter period of time into the system. However when increasing the frequency steps, less probes will be activated. The signal to noise ratio can be improved or optimized by choosing a good, improved or optimal step size taken into account the relaxation times of the probes. By way of illustration, for one example the frequency steps, also referred to as frequency grating, can be selected such that the first echo after the pulse train occurs just after the end of the ring-down of the antennas. The ring-down is selected smaller than the time for alignment with the Z-axis. After ring down and before alignment, an optimum signal to noise ratio can be obtained.

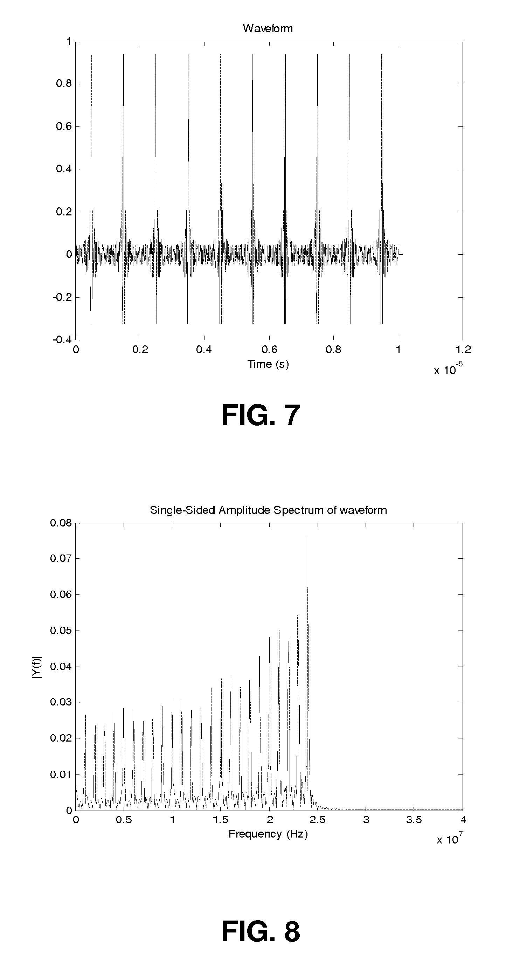

In one embodiment, the shape of the pulses in the pulse train may be adapted in order to improve or optimize the response of the probes. The latter may be particularly suitable for probes having a broad line width. By shaping the pulses, the amplitude and/or phase of each of the individual frequencies excited by the excitation pulse can be modified such that each of the probes, e.g. spins, can generate a good, improved or maximum signal. In one embodiment, the amplitude, corresponding with the excitation power provided, for a plurality of or for each of the composing frequencies can be separately modified to match with the individual probes. By way of illustration, FIG. 7 and FIG. 8 illustrate an excitation pulse train and its Fourier Transform for the situation whereby at lower frequencies less power is required to induce a probe spin flip of 90 degrees and at higher frequencies more power is required. It can be seen that by tuning the shape of the pulses in time domain, the corresponding frequency domain excitation provides the appropriate excitation power. In one embodiment, the excitation pulse train may, alternatively or in addition thereto, also be adapted to compensate effects induced by the transfer function of the antenna used for detecting the echo reply.

In one embodiment, optimization can be done by choosing the optimal bandwidth of the pulse train, depending on the line width of the probes to be measured.

In one embodiment, the present invention relates to a method and system as described above, wherein furthermore the excitation pulse train is adapted for exploiting correlation between the excitation pulses and the echo response. The number of frequencies, the spacing between the frequencies, the amplitude and the phase of each of the frequencies may be particularly tuned. As the signature of the excitation pulses in the pulse train and the echo pulses in the echo response are the same, the signal to noise ratio can be increased using spread spectrum techniques. Therefore pulses with different shapes may be used. Any of the frequencies can have a specific amplitude/phase. In one example, the resulting transmit sequence can be applied to the probes. When correlating the transmitted signal with the received signal coming from the probes, the resulting signal will be maximum for those probes which are excited with the corresponding pulse train. In a multiple antenna setup this could be used to distinguish between the different antennas. Different pulse shapes also can be used to obtain a better space resolution.

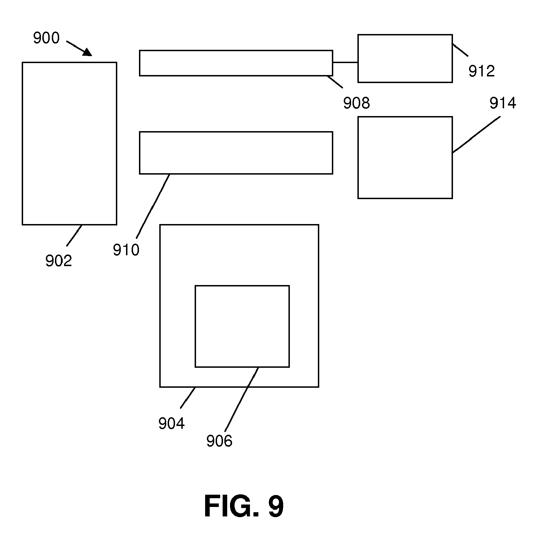

In some embodiments, the present invention relates to a system for performing pulsed electron paramagnetic resonance. Such a system advantageously may be adapted for performing a method as described in more detail above. The system 900, an example according to one embodiment being shown in FIG. 9, typically comprises a static magnetic field generator 902. Such a static magnetic field generator or generating means 902 may be any type of magnetic field generator such as for example a permanent magnet, an electromagnet. The system 900 comprises a magnetic excitation pulse train generator or generating means 904, adapted for generating an magnetic excitation pulse train. Such a magnetic excitation pulse train generator 904 may be of any suitable means, such as for example an electromagnet antenna. The magnetic excitation pulse train generator 904 may be adapted for generating an excitation pulse train so that an echo response is generated by the probes based on positive interference between the responses . The magnetic excitation pulse train generator 904 may comprise a controller 906 adapted for controlling the magnetic excitation pulse train generator 904 accordingly. Such a controller 906 may for example be implemented as software run on a processor or as hardware. Alternatively, the controller may be a separate component co-operating with the magnetic excitation pulse train generator 904. The system 900 furthermore comprises a detection means or detector 908, adapted for detecting an echo response from the object under study. Such a detector 908 may be a receiving antenna. The system furthermore may comprise one or more of an object holder 910, such as for example an object table, a scanning system 912 for detecting information in a topological manner, a processor 914 for processing the results obtained with the detector 908 the obtained results, etc. Other features may be as known in known pulsed electron paramagnetic resonance systems or may be features expressing functionality as described above for the pulsed EPR method.

In a second aspect, the present invention relates to a method for preparing pulsed electron paramagnetic resonance measurements. The method comprises designing an excitation pulse train adapted for inducing an echo response from probes, e.g. probes having a wide linewidth, based on positive interference between the individual frequencies that are excited by the excitation pulse train Designing thereby may take into account adjusting or selecting the characteristics of the excitation pulse train to improve or optimize signal to noise ratio, for example by selecting an appropriate step size between the frequencies used for the excitation pulse train. Designing, in addition or alternatively also may comprise adjusting or selecting a particular pulse shape, for example selecting an appropriate amplitude or phase for one, more or each of the frequencies used in the excitation pulse train. Designing may, in addition or alternatively thereto, comprise selecting an optimal bandwidth, depending on the line width of the probes to be measured. As indicated above, in one example the frequencies could be selected such that the first echo signal after the pulse train is just after the end of the ring-down of the antennas, resulting in an optimum signal that can be measured.

In further aspects, embodiments of the present invention also relate to computer-implemented methods for performing pulsed EPR or designing pulsed EPR experiments as indicated above or as can be obtained by the functionality of the system described above. Embodiments of the present invention also relate to corresponding computing program products or a controller for controlling a system for performing pulsed EPR or designing pulsed EPR experiments as described above. Such methods may be implemented in a computing system, such as for example a general purpose computer. The computing system may comprise an input means and a data processor, which may be set up as a single data processor or as a plurality of processors. The computing system may include a processor, a memory system including for example ROM or RAM, an output system such as for example a CD-rom or DVD drive or means for outputting information over a network. Conventional computer components such as for example a keybord, display, pointing device, input and output ports, etc also may be included. Data transport may be provided based on data busses. The memory of the computing system may comprise a set of instructions, which, when implemented on the computing system, result in implementation of the standard steps of the method as set out above and optionally of the optional steps as set out above. Therefore, a computing system including instructions for implementing the method for performing or designing pulsed EPR is not part of the prior art.

Further aspect of embodiments of the present invention encompass computer program products embodied in a carrier medium carrying machine readable code for execution on a computing device, the computer program products as such as well as the data carrier such as dvd or cd-rom or memory device. Aspects of embodiments furthermore encompass the transmitting of a computer program product over a network, such as for example a local network or a wide area network, as well as the transmission signals corresponding therewith.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing the claimed invention, from a study of the drawings, the disclosure and the appended claims.

## Claims

1. A method for performing pulsed electron paramagnetic resonance, the method comprising
- generating an excitation pulse train for applying to an object comprising probes, and
- detecting from the probes an echo response induced by the excitation pulse train.

2. A method according to claim 1, wherein generating an excitation pulse comprises generating an excitation pulse inducing positive interference effects between responses of probes for forming the echo response.

3. A method according to any of the previous claims, wherein detecting an echo response comprises topologically imaging echo responses from probes distributed in the object.

4. A method according to any of the previous claims, wherein generating an excitation pulse comprises selectively exciting predetermined frequencies of broadband probes of interest.

5. A method according to any of the previous claims, wherein detecting an echo response comprises detecting an echo response from single domain particles.

6. A method according to claim 5, wherein detecting an echo response comprises detecting an echo response from wideband resonance super paramagnetic particles.

7. A method according to any of the previous claims, wherein generating an excitation pulse train comprises
generating a sequence of EPR pulses wherein the shape of the different EPR pulses is adapted for compensating at least partly for frequency dependency of the resonance of spin probes in the object.

8. A method according to any of the previous claims, wherein generating an excitation pulse train comprises
generating a sequence of EPR pulses, whereby the intensity of the different EPR frequencies is adapted for compensating at least partly for power dependency of the resonance of spin probes in the object or of a detection system.

9. A method according to any of the previous claims, the method also comprising generating a static magnetic field for applying to the object comprising spins for providing an initial alignment of the spins, wherein generating an excitation pulse train comprises generating pulses having a substantially different orientation than the static magnetic field.

10. A system (900) for performing pulsed electron paramagnetic resonance, the system comprising
- an excitation pulse train generator (904) for generating an excitation pulse train for applying to an object comprising probes, and
- a detection means (908) for detecting from the probes an echo response induced by the excitation pulse train.

11. A system (900) according to claim 10, wherein the excitation pulse train generator (904) comprises a controller (906) for selectively exciting predetermined frequencies of broadband probes of interest and for generating an excitation pulse train positive interference effects between responses of probes for forming the echo response.

12. A system (900) according to any of claims 10 to 11, wherein the detection means is adapted for topologically imaging echo responses from probes distributed in the object.

13. A method for preparing pulsed electron paramagnetic resonance measurements. The method comprises designing an excitation pulse train adapted for inducing an echo response from probes, e.g. probes having a wide linewidth, based on positive interference between the individual responses of the probes to the individual frequencies of the excitation pulse train.

14. A computer program product for, when executed on a computing device, performing a method according to any of claims 1 to 9 or 13.

15. A data carrier comprising a computer program product according to claim 14.
